(19) **Europäisches Patentamt European Patent Office Office européen des brevets**

(11) **EP 1 476 872 B1**

(12) **FASCICULE DE BREVET EUROPEEN**

(45) Date de publication et mention
de la délivrance du brevet:
**10.06.2009 Bulletin 2009/24**

(51) Int Cl.:
*G11C 5/00* (2006.01)     *G11C 14/00* (2006.01)
*H03K 3/356* (2006.01)

(21) Numéro de dépôt: **03718863.8**

(22) Date de dépôt: **11.02.2003**

(86) Numéro de dépôt international:
**PCT/FR2003/000444**

(87) Numéro de publication internationale:
**WO 2003/069626 (21.08.2003 Gazette 2003/34)**

(54) **EXTRACTION D'UN CODE BINAIRE A PARTIR DE PARAMETRES PHYSIQUES D'UN CIRCUIT INTEGRE**

ABLEITUNG EINES BINÄREN KODES VON PHYSISCHEN PARAMETERN EINER INTEGRIERTEN SCHALTUNG

EXTRACTION OF A BINARY CODE FROM PHYSICAL PARAMETERS OF AN INTEGRATED CIRCUIT

(84) Etats contractants désignés:
**DE FR GB IT**

(30) Priorité: **11.02.2002 FR 0201638**

(43) Date de publication de la demande:
**17.11.2004 Bulletin 2004/47**

(73) Titulaire: **STMicroelectronics S.A.
92120 Montrouge (FR)**

(72) Inventeurs:
• **WUIDART, Luc
F-83190 Pourrières (FR)**

• **MALHERBE, Alexandre
F-13530 Trets (FR)**
• **BARDOUILLET, Michel
F-13790 Rousset (FR)**

(74) Mandataire: **de Beaumont, Michel
Cabinet Michel de Beaumont
1, rue Champollion
38000 Grenoble (FR)**

(56) Documents cités:
**EP-A- 0 863 546          GB-A- 2 107 541
US-A- 3 636 530          US-A- 3 911 368
US-A- 4 023 110          US-A- 5 608 645
US-A- 5 686 850          US-A1- 2001 050 952**

## Description

La présente invention concerne le stockage, dans un circuit intégré, d'un code binaire immuable. L'invention concerne plus particulièrement l'extraction, d'un circuit intégré, d'un code binaire issu de paramètres liés à la fabrication de ce circuit. De tels paramètres liés à la fabrication sont généralement appelés des paramètres physiques et sont alors issus d'un réseau de paramètres physiques (PPN). On utilise un code binaire ainsi "enfoui" dans un circuit intégré, par exemple, pour éviter son stockage permanent sous forme de mot numérique dans un registre ou analogue et pour empêcher une détection de ce code. Dans une application à l'identification d'un élément ou ensemble électronique à partir de paramètres liés à la fabrication d'un circuit d'identification contenu dans une puce de circuit intégré, cette identification est couramment désignée par l'expression anglosaxonne "integrated circuit fingerprint".

La présente invention concerne plus particulièrement l'extraction d'un code binaire stocké sous la forme de chemins électriques au moins partiellement résistifs et interprété par des bascules ou équivalent. Des exemples de circuits de stockage de tels codes binaires, et d'identification d'une puce de circuit intégré par de tels codes, sont décrits dans les demandes de brevet français déposées sous les numéros 01/04583 et 01/04585 par la demanderesse.

Le principe utilisé par ces circuits est de faire circuler un même front électrique déclencheur d'une lecture dans des chemins électriques différents arrivant sur différentes bascules. Selon que le retard d'un chemin donné est inférieur ou supérieur à un retard de référence ou retard moyen synchronisant la lecture des bascules, l'état de sortie de la bascule correspondante est 0 ou 1. Les sorties des différentes bascules fournissent alors le code binaire stocké sous forme de chemins électriques. Ces chemins électriques peuvent être rendus différents simplement par la longueur des pistes les constituant, mais il est préférable qu'ils contiennent un élément résistif (en pratique associé à un élément capacitif constitué des grilles de transistors MOS constitutifs des bascules) pour constituer une cellule RC.

Un atout considérable d'un tel stockage d'un code binaire est qu'il est stocké, non pas directement sous forme numérique, mais en quelque sorte sous une forme analogique, ce qui rend plus difficile son piratage.

Dans les circuits susmentionnés, pour répondre à l'objectif de rendre invisible le code stocké par les chemins électriques, on doit veiller à ce que ces chemins ne soient pas trop différents (en termes de longueur) par rapport au chemin électrique apportant le retard de référence. Dans le cas contraire, on risque de permettre une détection optique selon que le chemin est manifestement plus long ou plus court que le chemin de référence.

Par ailleurs, dans certains cas et de façon parfaitement aléatoire et imprévisible, un chemin électrique d'une des bascules peut, associé à la propagation du front dans cette bascule, présenter exactement le même retard que le chemin moyen. On risque alors, pour cette bascule, d'avoir un état de sortie non reproductible d'une extraction à une autre du code binaire.

Ces deux imperfections des circuits de stockage susmentionnés sont liées à l'utilisation d'un retard moyen pour synchroniser la lecture des bascules.

Le document US-A-3 636 530, ce qui révèle le préambule des réclamations indépendantes, décrit une cellule bistable de stockage non volatil comportant deux résistances dans les branches respectives d'une cellule, chaque branche contenant un transistor de sélection de la cellule.

Le document GB-A-2 107 541 décrit une cellule bistable de mémoire volatile utilisant des résistances en silicium polycristallin.

L'invention vise à améliorer l'extraction d'un code binaire enfoui dans un circuit intégré.

L'invention vise également à proposer un circuit de stockage d'un code binaire issu de paramètres physiques d'un circuit intégré qui pallie les imperfections des circuits susmentionnés. Plus particulièrement, l'invention vise à éviter le recours à un chemin électrique commun, de référence ou moyen, pour comparer les chemins électriques associés aux différentes bascules.

L'invention vise également à rendre indétectables les retards apportés par les différents chemins électriques d'un tel circuit.

L'invention vise également à proposer une solution qui soit compatible avec la technologie couramment utilisée pour la réalisation de transistors MOS et qui, en particulier, n'engendre pas d'étape supplémentaire de fabrication.

Pour atteindre ces objets et d'autres, la présente invention prévoit une cellule intégrée comportant les dispositifs de la revendication 1.

Selon un mode de réalisation de la présente invention, ladite diminution de valeur est provoquée en imposant temporairement, dans la résistance correspondante, la circulation d'un courant qui soit supérieur au courant pour lequel la valeur de cette résistance est maximum.

Selon un mode de réalisation de la présente invention, chaque branche comporte en outre un transistor de stabilisation reliant sa borne de sortie à ladite borne d'application de tension opposée à celle à laquelle est connectée la résistance de la branche concernée.

Selon un mode de réalisation de la présente invention, les transistors de stabilisation servent à provoquer ladite diminution de la valeur d'une des résistances.

Selon un mode de réalisation de la présente invention, ladite tension est choisie entre une tension relativement faible de lecture et une tension relativement élevée de stabilisation de l'état initial de la cellule.

Selon un mode de réalisation de la présente invention, lesdits transistors sont des transistors MOS à canal N.

Selon un mode de réalisation de la présente invention, lesdits transistors sont des transistors MOS à canal P.

Selon un mode de réalisation de la présente invention, lesdites résistances de différenciation sont des résistances passives.

L'invention prévoit également un procédé de commande en stabilisation de la valeur d'une cellule comprenant les dispositifs de la revendication 8.

Selon un mode de mise en oeuvre de la présente invention, le courant de contrainte est choisi dans une table prédéterminée de correspondance entre le courant de contrainte et la résistance finale souhaitée.

L'invention prévoit également un circuit de stockage et d'extraction d'un code binaire sur n bits dans une puce de circuit intégré comportant

n cellules intégrées d'extraction d'une valeur binaire ; et
une unité centrale de commande.

Selon un mode de réalisation de la présente invention, les n bits contenus dans les cellules sont extraits en parallèle.

L'invention prévoit également un circuit d'identification d'une puce de circuit intégré comprenant un circuit de stockage et d'extraction d'un code binaire.

Ces objets, caractéristiques et avantages, ainsi que d'autres de la présente invention seront exposés en détail dans la description suivante de modes de mise en oeuvre et de réalisation particuliers faite à titre non limitatif en relation avec les figures jointes parmi lesquelles :

la figure 1 représente un mode de réalisation d'une cellule intégrée de stockage d'un bit sous forme de chemin électrique selon la présente invention ;
la figure 2 représente, par une vue partielle en perspective très schématique, un mode de réalisation d'une résistance en silicium polycristallin constitutive d'un chemin électrique selon la présente invention ;
la figure 3 illustre, par un réseau de courbes, la stabilisation de la valeur d'un chemin électrique selon un mode de mise en oeuvre de la présente invention ; et
la figure 4 représente, sous forme de blocs, un mode de réalisation d'un circuit de stockage et d'extraction d'un code binaire selon l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les différents circuits de lecture et d'exploitation des mots binaires stockés dans un circuit selon l'invention n'ont pas été détaillés. L'invention peut être mise en oeuvre quelle que soit l'exploitation faite du code binaire fonction des paramètres physiques du circuit intégré. De plus, la réalisation pratique d'une résistance en silicium polycristallin par dépôt et gravure n'a pas été détaillée, l'invention pouvant être mise en oeuvre sur une résistance formée de façon classique.

Une caractéristique de la présente invention est de prévoir, au sein même de chaque élément de lecture ou d'extraction de type bistable ou bascule fournissant un bit d'un code binaire enfoui, un chemin électrique de référence à comparer avec un chemin électrique représentatif du bit enfoui. Plus précisément, l'invention prévoit, pour chaque bit d'un code binaire mémorisé sous la forme de chemins électrique ayant des constantes de temps différentes, une structure différentielle d'extraction du bit correspondant.

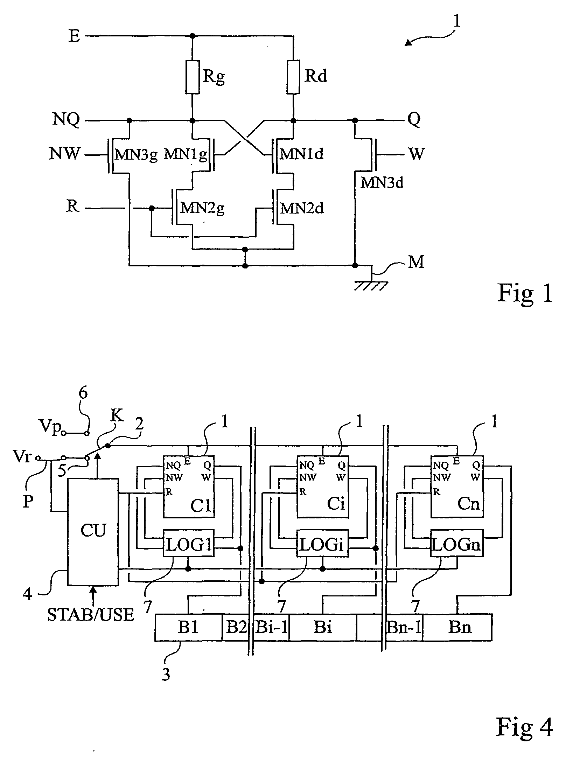

La figure 1 représente le schéma électrique d'une cellule 1 d'extraction d'un bit stocké sous la forme d'un chemin électrique selon un mode de réalisation de la présente invention.

La cellule 1 comprend deux branches parallèles de constitution identique entre deux bornes E et M d'application d'une tension, la borne M représentant la masse. Cette tension qui alimente la cellule est, comme on le verra par la suite, différente selon que l'on effectue une extraction ou lecture du bit, ou une étape caractéristique de stabilisation de ce bit.

Une première branche, dite droite dans l'orientation de la figure, comporte en série, une résistance Rd, un premier transistor MOS de lecture MN1d, et un deuxième transistor MOS de sélection MN2d. L'interconnexion entre la résistance Rd et le transistor MN1d (donc le drain de ce transistor) constitue une première borne Q de sortie dite arbitrairement directe (non inversée). Une deuxième branche, dite gauche dans l'orientation de la figure, comporte en série, une résistance Rg, un premier transistor MOS de lecture MN1g, et un deuxième transistor MOS de sélection MN2g. L'interconnexion entre la résistance Rg et le transistor MN1g (donc le drain de ce transistor) constitue une deuxième borne NQ de sortie inverse par rapport à la borne Q. La grille du transistor MN1g est reliée à la borne Q tandis que la grille du transistor MN1d est reliée à la borne NQ pour obtenir l'effet bistable recherché. Les grilles des transistors MN2g et MN2d sont reliées ensemble à une borne R destinée à recevoir un signal de sélection en lecture de la cellule 1. Dans l'exemple représenté, tous les transistors sont à canal N.

Selon l'invention, les résistances Rg et Rd sont, en fabrication, dimensionnées de façon identique pour avoir la même valeur. Ces résistances font partie des chemins électriques associés à la cellule 1. Elles définissent, chacune avec la grille du transistor de la branche opposée avec laquelle elles sont respectivement reliées, une cellule RC. Ces cellules RC conditionnent les constantes de temps des chemins électriques reliant la borne E aux bornes Q et NQ, respectivement.

Le fonctionnement d'une cellule selon l'invention telle que décrite ci-dessus est, en lecture, le suivant. La borne d'entrée R reçoit un signal de configuration en lecture ou d'extraction (état haut), rendant conducteur les deux transistors MN2g et MN2d.

Par la suite, on applique un front (positif avec les polarités de ce mode de réalisation) sur l'entrée E de la cellule décrite ci-dessus. L'apparition de ce front sur les bornes Q et NQ devrait être simultanée si les composants étaient tous rigoureusement identiques. En pratique, ce n'est pas le cas, ne serait-ce qu'en raison des dispersions technologiques et de procédé de fabrication. Il en découle qu'une des bornes Q et NQ voit son potentiel croître plus vite que l'autre. Ce déséquilibre provoque la conduction d'un des transistors MN1g et MN1d. En raison du croisement des grilles de ces transistors, celui qui conduit le premier est celui dont la grille participe au chemin électrique de constante de temps la plus faible, donc celui dont le potentiel de drain croît moins vite que l'autre. Une fois conducteur, ce transistor MN1 force son drain (donc la borne de sortie Q ou NQ correspondante) à la masse, ce qui confirme le blocage du transistor MN1 de l'autre branche, donc l'état haut sur la borne de sortie correspondante.

En supposant que la constante de temps ne diffère qu'en raison d'une différence entre les résistances (ou que les autres dispersions sont négligeables par rapport à l'écart de valeur entre les résistances), la résistance de valeur la plus faible engendre une constante de temps plus faible.

La durée du signal d'extraction appliqué sur l'entrée E n'a pas d'importance. Il s'agit d'un signal "numérique" à deux états, l'extraction ou lecture étant provoquée, dans cet exemple, par le front montant. Par la suite, la disparition de l'état haut supprime l'alimentation de la cellule, donc le bit stocké.

Pour préserver le caractère indécelable du code et le rendre dépendant des dispersions technologiques et de procédés de fabrication, il est important que les résistances Rg et Rd soient prévues identiques et que seule leur dispersion (par essence, non observable) conditionne, en sortie de fabrication, le bit extrait de la cellule. Même si les résistances Rg et Rd sont rigoureusement identiques, la constitution de la cellule 1 fait qu'elle ne peut pas présenter un état indéterminé. Elle prendra forcément un état, par exemple, selon d'autres dispersions (entre les transistors, entre les chemins amenant le front depuis la borne E, etc.).

On voit déjà apparaître un avantage de l'invention qui est que, pour lire le contenu d'une cellule, aucune comparaison par rapport à un élément externe à la cellule n'est nécessaire.

Pour garantir une reproductibilité de l'état (bit) de la cellule à chaque lecture, on prévoit, selon une autre caractéristique de l'invention, de stabiliser ce contenu lors d'une première lecture. En d'autres termes, lors d'une phase de mise en route, de première utilisation, de configuration ou analogue, on effectue une première lecture du bit issu des paramètres physiques, puis on déclenche une étape de stabilisation de la cellule.

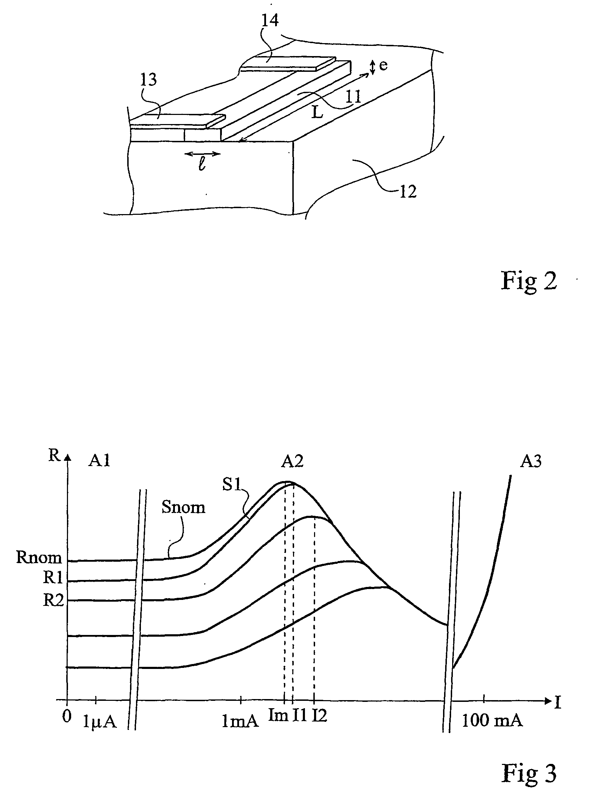

Pour ce faire, les résistances Rg et Rd sont, selon une caractéristique de l'invention, des résistances en silicium polycristallin dont les valeurs respectives peuvent faire l'objet d'une diminution irréversible, comme cela sera exposé par la suite en relation avec les figures 2 et 3. Pour l'instant, on se contente de noter que si la résistance Rg ou Rd est soumise à un courant, dit de stabilisation, supérieur au courant pour lequel sa valeur est maximale, on assiste à une diminution irréversible de la valeur de sa résistance lorsque l'on revient à des courants situés dans la plage nominale de fonctionnement. La plage nominale des courants de fonctionnement d'une résistance en silicium polycristallin utilisée selon l'invention est inférieure à la centaine de microampères et, le plus souvent, inférieure à la dizaine de microampères. L'amplitude des courants de stabilisation est de l'ordre de quelques milliampères.

Selon l'invention, l'étape de stabilisation consiste à soumettre à un courant élevé par rapport à la plage de courants de fonctionnement, la résistance de la branche qui a, lors d'une première lecture, présenté un état haut (indiquant donc, en principe une résistance de valeur moindre). Cela confirme alors l'état de la cellule en diminuant de façon notable la valeur de cette résistance. Bien sûr, le courant de stabilisation ne doit pas être appliqué à l'autre résistance, faute de quoi, elle subirait une diminution de valeur identique, ce qui annulerait l'effet de confirmation escompté.

Pour imposer, dans l'une des résistances Rg et Rd, un courant de stabilisation, supérieur aux courants de fonctionnement de cette résistance, la borne E sert, en phase de stabilisation, d'application d'un potentiel continu d'alimentation Vp (ici positif). Ce potentiel d'alimentation est, selon l'invention, supérieur au potentiel Vr d'utilisation de la cellule en lecture, c'est-à-dire au potentiel haut du front appliqué sur la borne E. De plus, on prévoit deux transistors MOS MN3d et MN3g (dans cet exemple à canal N) respectivement associés à chacune des branches en reliant la borne Q, respectivement NQ à la masse. Les grilles respectives des transistors constituent deux bornes W et NW d'entrée de commande en stabilisation de la cellule. Un seul des transistors MN3g et MN3d est destiné à être rendu passant pendant l'étape de stabilisation.

Celui des transistors MN3g et MN3d qui est passant court-circuite les deux autres transistors MN1 et MN2 de la branche concernée, et impose la circulation d'un courant dans la résistance Rg ou Rd de cette branche. Le potentiel Vp de stabilisation est choisi pour que le courant qui circule alors dans la résistance Rg ou Rd soit supérieur au courant pour lequel cette résistance présente une valeur maximale. Cette caractéristique de l'invention ressortira mieux de la description qui sera faite par la suite en relation avec les figures 2 et 3.

Les transistors MN2g et MN2d de la cellule doivent être bloqués dans la phase de stabilisation (entrée R au niveau bas). Ils servent à protéger les transistors de lecture MN1g et MN2g en rendant leurs sources flottantes, évitant ainsi l'apparition de tensions grille-source destructrices en raison de la tension d'alimentation Vp.

De plus, en déconnectant les transistors MN1, les transistors MN2 empêchent qu'ils voient à leurs bornes la tension élevée Vp. Par conséquent, les transistors MN1 et MN2 peuvent être dimensionnés en fonction de la tension de lecture Vr. Seuls les transistors MN3g et MN3d ont besoin d'être dimensionnés pour tenir la tension Vp et supporter le courant relativement élevé (par rapport à la plage de fonctionnement en lecture) servant à stabiliser la cellule.

La figure 2 représente un mode de réalisation d'une résistance en silicium polycristallin utilisée pour former les résistances Rd et Rg d'une cellule selon l'invention.

Une telle résistance (désignée par 11 en figure 2) est constituée d'une piste (dite aussi barreau) en silicium polycristallin obtenue par gravure d'une couche déposée sur un substrat 12 isolant. Le substrat 12 est indifféremment directement constitué du substrat du circuit intégré ou est constitué d'une couche isolante formant un substrat isolant ou équivalent pour la résistance 11. La résistance 11 est connectée, par ses deux extrémités, à des pistes conductrices (par exemple, métalliques) 13 et 14 destinées à raccorder le barreau résistif aux autres éléments du circuit intégré. La représentation schématique de la figure 2 ne fait pas référence aux différentes couches isolantes et conductrices constituant généralement le circuit intégré. Pour simplifier, on s'est contenté de représenter le barreau résistif 11 posé sur le substrat isolant 12 et en contact, par les extrémités de sa face supérieure, avec les deux pistes métalliques 13 et 14. En pratique, les liaisons de l'élément résistif 11 aux autres composants du circuit intégré sont obtenues par des pistes plus larges en silicium polycristallin partant des extrémités du barreau 11 dans l'alignement de celui-ci. En d'autres termes, l'élément résistif 11 est généralement formé en rendant un tronçon d'une piste en silicium polycristallin plus étroit que le reste de la piste.

La résistance R de l'élément 11 est donnée par la formule suivante :

$$R = \rho (L/s),$$

où p désigne la résistivité du matériau (silicium polycristallin le cas échéant dopé) constituant la piste dans laquelle est gravé l'élément 11, où L désigne la longueur de l'élément 11, et où s désigne sa section, c'est-à-dire sa largeur 1 par son épaisseur e. La résistivité p de l'élément 11 dépend, entre autres, du dopage éventuel du silicium polycristallin le constituant.

Le plus souvent, lors de la réalisation d'un circuit intégré, on prévoit les résistances en faisant référence à une notion dite de résistance par carreau $R_\square$ (square résistance). Cette résistance par carreau se définit comme étant la résistivité du matériau divisée par l'épaisseur avec laquelle il est déposé. En reprenant la relation ci-dessus donnant la résistance d'un élément 11, la résistance est donc donnée par la relation :

$$R = R_\square * L/1.$$

Le quotient L/1 correspond à ce que l'on appelle le nombre de carreaux (square number) constituant l'élément résistif 11. Cela représente, vu de dessus, le nombre de carreaux de dimension donnée fonction de la technologie, mis côte à côte pour former l'élément 11.

La valeur de la résistance en silicium polycristallin est donc définie, à la fabrication, d'après les paramètres ci-dessus, conduisant à des résistivités et résistances dites nominales. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Une caractéristique de la présente invention est d'imposer temporairement, dans une résistance en silicium polycristallin (Rg ou Rd) dont on souhaite diminuer irréversiblement la valeur pour stabiliser l'état de la cellule, un courant de programmation ou de contrainte supérieur à un courant pour lequel la résistance passe par une valeur maximale, ce courant étant au-delà de la plage de courants de fonctionnement normal (en lecture) de cette résistance. En d'autres termes, on diminue la résistivité du silicium polycristallin dans la plage de courants de fonctionnement, de façon stable et irréversible, en imposant temporairement dans l'élément résistif correspondant la circulation d'un courant au-delà de la plage de courants de fonctionnement.

Une autre caractéristique de l'invention est que le courant servant à diminuer la valeur de la résistance est, à la différence d'un élément fusible, non destructif pour l'élément en silicium polycristallin.

La figure 3 illustre, par un réseau de courbes donnant la résistance d'un élément en silicium polycristallin du type de celui représenté en figure 2 en fonction du courant le traversant, un mode de mise en oeuvre de la présente invention pour stabiliser une cellule par diminution de la valeur d'une de ses résistances.

On suppose que le silicium polycristallin ayant servi à la fabrication de l'élément résistif 11 (Rg ou Rd) présente une résistivité nominale conférant à l'élément 11, pour les dimensions 1, L et e données, une valeur de résistance $R_{nom}$. Cette valeur nominale (d'origine) de la résistance correspond à la valeur prise de façon stable par l'élément résistif 11 dans la plage de courants de fonctionnement du système, c'est-à-dire généralement pour des courants inférieurs à 100 $\mu$A.

Selon l'invention, pour diminuer la valeur de la résistance et passer de façon irréversible et stable, par exemple, à une valeur R1 inférieure à $R_{nom}$, on applique aux bornes de l'élément résistif 11 un courant (par exemple I1), dit de contrainte, supérieur à un courant Im pour lequel la valeur de la résistance R de l'élément 11 est maximale sans toutefois être infinie. Comme l'illustre la figure 3, une fois que ce courant I1 a été appliqué à l'élément résistif 11, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 μA) . Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 3, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique de stabilisation, hors du fonctionnement normal en extraction (plage A1) du circuit intégré, c'est-à-dire hors du fonctionnement normal de la résistance.

Théoriquement, une fois que la valeur de la résistance en silicium polycristallin a été abaissée vers une valeur inférieure (par exemple R1 en figure 3), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$. Dans l'application à une cellule différentielle d'extraction d'un bit telle que représentée en figure 1, cela montre le caractère irréversible de la stabilisation apportée. Une deuxième phase de stabilisation ne fait, au plus, qu'accroître la diminution de la valeur de la résistance par rapport à sa valeur nominale, donc ne fait que confirmer encore l'état de la première détection.

On voit que toutes les allures de la résistance en fonction du courant se rejoignent sur la pente de décroissance de la valeur de la résistance, après être passées par le maximum de l'allure. Ainsi, pour un élément résistif donné (p, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint.

Bien sûr, on veillera à ne pas dépasser la plage de courants de programmation $A_2$ (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin selon l'invention ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 2, on réalisera des vias dans l'isolant sur-jacent (non représenté) du barreau de silicium polycristallin pour connecter des pistes métalliques 13 et 14 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes données. En d'autres termes, pour un élément de dimensions données, cela conditionne le point de départ de la valeur de la résistance, et par voie de conséquence, les valeurs de résistance obtenues pour des courants de contrainte données.

Pour être en mesure d'appliquer les bonnes valeurs, on prédétermine, par exemple par mesures, les différents courants à appliquer pour passer des différentes valeurs de résistance à des valeurs inférieures. Par exemple, on utilise une résistance de test que l'on soumet à une augmentation par pallier du courant, en revenant après chaque augmentation dans la plage des courants de fonctionnement pour mesurer la valeur obtenue de résistance. Les valeurs mesurées vont suivre la courbe Snom. Par conséquent, on pourra déterminer les courants (I1, I2, figure 3) et les résistances associées (R1, R2). L'écart entre les valeurs de la table ainsi obtenue dépend du pas choisi pour l'augmentation par pallier du courant de contrainte. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 3 peuvent également être lues comme allure de la résistance par carreau, on est en mesure de transposer les valeurs calculées aux différentes résistances d'un circuit intégré définies par les largeurs et longueurs des tronçons résistifs. On est alors en mesure de prédéterminer la valeur du courant de contrainte à appliquer à l'élément résistif pour diminuer, de façon irréversible et stable, sa valeur. Cette détermination permet de fixer la tension Vp utilisée dans la phase de stabilisation. On notera qu'en raison de l'effet souhaité (diminution notable de la valeur d'une des deux résistances appariées), la précision du courant de contrainte n'est pas critique pourvu d'être supérieur au courant maximum Im de la résistance. De préférence, on prendra en pratique une marge de sécurité confortable pour éviter que des variations de la tension Vp ou autres tolérances du circuit empêchent d'obtenir la diminution de valeur. Par exemple, on paramètrera le circuit en fonction d'un courant de stabilisation donnant une valeur de résistance inférieure à la moitié de la valeur nominale.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si compte tenu des mesures de prédétermination, on considère ne pas pouvoir négliger l'influence de la durée d'application de la contrainte, le mode préféré de mise en oeuvre (prédéterminer des valeurs de contraintes en durée et en intensité) est parfaitement compatible avec la prise en compte de la durée d'application de la contrainte.

A titre d'exemple particulier de mise en oeuvre, on a réalisé une résistance en silicium polycristallin dopée N+ ayant une section de 0,225 micromètre carré (1 = 0,9 $\mu$m, e = 0,25 $\mu$m) et une longueur L de 45 micromètres. Avec le silicium polycristallin utilisé et le dopage correspondant, la résistance nominale était d'environ 6300 Ohms. Cela correspond à une résistance par carreau d'environ 126 Ohms (50 carreaux). En appliquant à cette résistance un courant supérieur à trois milliampères, on a provoqué une diminution de sa valeur, stable pour un fonctionnement sous des courants allant jusqu'à 500 microampères. Avec un courant de 3,1 milliampères, la valeur de la résistance a été abaissée à environ 4500 Ohms. En appliquant à la résistance un courant de 4 milliampères, on a diminué la valeur de la résistance jusqu'environ 3000 Ohms. Les valeurs obtenues de résistances ont été les mêmes pour des durées de contraintes allant de 100 microsecondes à plus de 100 secondes.

Bien entendu, les exemples ci-dessus ainsi que les ordres de grandeurs donnés de courants et de résistances pour les différentes plages concernent les technologies actuelles. Les courants des plages A1, A2 et A3 pourront être différents (inférieurs) pour des technologies plus avancées et peuvent être transposés à des densités de courant. Le principe de l'invention n'en est pas modifié. On a toujours trois plages et on utilise la plage intermédiaire pour forcer la diminution de résistivité.

Un avantage de la présente invention est qu'elle est compatible avec les technologies classiques de réalisation des transistors MOS.

Un autre avantage de l'invention est que la valeur intégrée dans les résistances est insensible aux Ultra Violets.

Un autre avantage de l'invention est que le code stocké dans l'élément de mémorisation n'est pas détectable optiquement à la différence d'une résistance en silicium polycristallin qui serait utilisée comme fusible où la détérioration physique du barreau de silicium rend la programmation visible.

Un autre avantage de l'invention est que la modification irréversible de la valeur de la résistance programmée n'est pas destructrice et ne risque donc pas d'endommager d'autres parties du circuit. Cela permet notamment de prévoir une diminution de la valeur de la résistance après fabrication, et même au cours de sa vie dans son circuit applicatif.

La figure 4 représente le schéma électrique d'un mode de réalisation d'un circuit de stockage intégré associant plusieurs cellules 1 du type de celle représentée en figure 1, pour extraire un mot ou code binaire de plusieurs bits.

Dans cet exemple, le circuit comporte une unique borne 2 d'entrée d'application, selon la phase de fonctionnement, du potentiel Vp ou d'un front de lecture au niveau Vr. Le circuit fournit un code binaire $B_1$, $B_2$, ..., $B_{i-1}$, $B_i$, ..., $B_{n-1}$, $B_n$ sur un nombre n de bits prédéterminé. Chaque bit Bi est fourni par une sortie (par exemple, Q) d'une cellule Ci (i étant compris entre 1 et n). Dans l'exemple de la figure 4, les différentes sorties Q des bascules 1 sont reliées individuellement en entrée d'un registre 3 de mémorisation du code binaire obtenu. Les détails de connexion et de constitution du registre 3 n'ont pas été représentés et ne font pas l'objet de la présente invention. Une fois le code binaire contenu dans ce registre, son exploitation dépend de l'application, et sa mise en oeuvre est à la portée de l'homme du métier.

Le circuit de la figure 4 comporte une unité centrale 4 (CU) commune à toutes les cellules 1. L'unité 4 a notamment pour rôle de placer les cellules dans un fonctionnement de lecture ou de stabilisation. Par exemple, l'unité 4 commande un sélecteur K de connexion de la borne 2 entre une borne 6 d'application de la tension continue Vp et une borne 5 sur laquelle sera appliqué, en lecture, un signal numérique (front d'amplitude Vr) de déclenchement de l'extraction du code. Par exemple, un interrupteur P (par exemple, un transistor MOS) relie la borne 5 à une borne d'application de la tension Vr.

L'unité 4 produit également un signal de commande à destination des bornes R des cellules Ci pour placer celles-ci dans une configuration de lecture ou de stabilisation, ainsi qu'un signal de commande de l'interrupteur P. Dans l'exemple représenté où la lecture s'effectue en parallèle, toutes les bornes R des cellules Ci sont reliées ensemble à la borne correspondante de l'unité 4. En variante, les cellules Ci peuvent être adressées individuellement (par exemple cycliquement) en lecture, pour une extraction en série des différents bits. Il convient alors de veiller à maintenir à l'état haut le signal d'extraction (fermeture de l'interrupteur P) le temps nécessaire à l'extraction de tous les bits.

Pour permettre une stabilisation ou confirmation d'une cellule, il est nécessaire d'en extraire une première fois le contenu et de commander en conséquence la conduction du transistor MN3g ou MN3d. Pour cela chaque cellule Ci est associée à un circuit logique 7 (LOGi) de lecture et d'interprétation pendant la phase de stabilisation.

Chaque circuit 7 comporte deux entrées de détection reliées respectivement aux bornes Q et NQ de la cellule, deux sorties de commande reliées respectivement aux bornes W et NW de commande des transistors MN3d et MN3g de la cellule, et une borne d'entrée de commande destinée à recevoir un signal de commande (d'activation/désactivation) de l'unité 4. Pour simplifier, on nommera les bornes d'entrée-sortie du circuit 7 qui sont reliées à la cellule 1 par les références des bornes de cette cellule. De préférence la stabilisation de toutes les cellules s'effectue en parallèle, c'est pourquoi chacune est associée à son circuit logique 7.

Lorsque le code doit être stabilisé, par exemple, lors d'une première utilisation du circuit, ou lors d'une phase de test après fabrication, un signal de commande STAB/USE que reçoit l'unité 4 déclenche une phase de stabilisation.

L'unité 4 commence par provoquer une extraction de tous les bits. Pour cela, elle place le sélecteur K dans un état où il sélectionne la borne 5, rend passant les transistors MN2 et active les circuits LOGi, puis provoque une commutation vers l'état haut du signal appliqué sur la borne 5. Pour cela, l'unité 4 rend l'interrupteur P passant pour faire apparaître un front positif sur les bornes E des cellules. La durée de fermeture de l'interrupteur P correspond à la durée d'une extraction normale. Dans chaque cellule, on assiste alors à l'apparition d'un état 0 ou 1 sur sa sortie Q. De préférence, toutes les cellules ont des paires de résistances Rg et Rd de mêmes valeurs.

La stabilisation va être décrite en relation avec une cellule, sachant toutefois qu'elle s'effectue de manière similaire pour les autres cellules.

Initialement, les sorties W et NW du circuit LOGi sont au repos (état bas), de sorte que les deux transistors MN3 sont bloqués. Dès que le circuit LOGi détecte un état 1 sur une de ses entrées Q, respectivement NQ, il commute vers l'état haut sa sortie W, respectivement NW, pour rendre conducteur le transistor MN3d, respectivement MN3g, et verrouille cet état conducteur ainsi qu'un état bas sur son autre sortie NW, respectivement W. Ce verrouillage de l'état bas permet de figer la commande par le circuit LOGi alors même que la commutation en fermeture d'un des transistors MN3 inverse l'état des sorties de la cellule. En variante, on peut prévoir d'invalider la détection des états sur les entrées Q et NQ dès qu'un état haut y a été détecté.

Selon un premier mode de réalisation correspondant au mode de réalisation représenté, l'unité 4 déclenche, après une durée prédéterminée choisie pour être supérieure (avec une marge de sécurité) à la durée maximale possible de verrouillage des différents circuits LOGi (qui dépend donc de la constante de temps maximale des différents chemins des cellules en particulier si des cellules différentes ont des valeurs nominales de paires de résistances différentes), l'ouverture des transistors MN2 (état bas sur toutes les entrées R), puis la commutation du sélecteur K vers la borne 6. Il en résulte la circulation d'un courant de stabilisation (de l'ordre de quelques milliampères) dans l'une des résistances de chaque cellule (celle qui correspond à la constante de temps détectée la plus faible). Ce courant dont la valeur est prédéterminée en fonction des caractéristiques nominales des résistances des cellules 1 comme cela a été exposé en relation avec la figure 3 est maintenu, par exemple, pendant une durée de quelques millisecondes. Cela provoque, dans chaque cellule, une diminution irréversible et stable de la valeur de la résistance associée à la constante de temps la plus faible, confirmant ainsi l'état de la cellule.

Puis, l'unité 4 désactive la phase de stabilisation en commutant de nouveau le sélecteur K vers la borne 5 (sans toutefois déclencher une nouvelle extraction par la fermeture de l'interrupteur P) et en désactivant les circuits logiques LOGi. Le cas échéant, l'unité 4 commute également vers un état haut le signal de commande des entrées R. En variante, ce signal est placé à l'état haut, à chaque phase d'extraction, ce qui minimise la consommation en dehors des phases d'extraction.

L'état de chaque cellule est donc désormais stabilisé (confirmé) sans pour autant être détectable. En effet, les résistances Rd et Rg de chaque cellule ont encore les mêmes dimensions.

Selon une variante de réalisation, chaque circuit logique LOGi est associé à un sélecteur entre les niveaux Vp et Vr et comprend une logique de commande en conséquence. Dans ce cas, il n'est pas nécessaire que toutes les cellules passent au niveau Vp en même temps.

En principe, l'étape de stabilisation n'est effectuée qu'une seule fois. Toutefois, il n'est pas gênant qu'elle soit reproduite. Elle ne fera que confirmer le même état.

Un avantage de la présente invention est qu'aucune précaution particulière n'est à prendre pour différencier les chemins électriques stockant le code. Au contraire, les résistances sont fabriquées de façon identique, ce qui accroît encore la dissimulation du code.

Un autre avantage de la présente invention est que le code stocké ainsi ne risque pas d'être détecté, même par une attaque par analyse de la consommation. En effet, la consommation d'une cellule reste inchangée en lecture quelle que soit celle des résistances Rd et Rg qui a vu sa valeur diminuer.

Bien entendu, la présente invention est susceptible de diverses variantes et modifications qui apparaîtront à l'homme de l'art. En particulier, les dimensionnements des résistances en silicium polycristallin en vue d'obtenir une valeur nominale dépendent de l'application et sont à la portée de l'homme du métier à partir des indications fonctionnelles données ci-dessus. De plus, les valeurs des contraintes en tension ou en courant pour la mise en oeuvre de l'invention sont à la portée de l'homme du métier à partir des indications fonctionnelles données ci-dessus. En outre, bien que l'invention ait été décrite en relation avec des transistors MOS à canal N, sa structure se transpose aisément à des transistors MOS à canal P, les résistances des cellules étant alors connectées au potentiel le plus bas (négatif) d'alimentation. Enfin, on notera que l'invention est aisément transposable d'une technologie à une autre.

**Revendications**

1. Cellule intégrée (1) d'extraction d'une valeur binaire à partir d'une propagation d'un front d'un signal de déclenchement dans deux chemins électriques, comprenant entre deux bornes (2, 3) d'application d'une tension, deux branches parallèles comprenant chacune, en série :

    une résistance (Rd, Rg) de différenciation des chemins électriques ;
    un transistor de lecture (MN1d, MN1g), le point milieu entre la résistance et le transistor de lecture de chaque branche définissant une borne de sortie (Q, NQ) de la cellule, et la grille du transistor de lecture de chaque branche étant reliée à la borne de sortie de l'autre branche ; et un transistor de sélection (MN2d, MN2g), **caractérisé en ce que** les résistances (Rd, Rg) sont en silicium polycristallin et sont dimensionnées pour avoir des valeurs nominales identiques, la cellule étant associée à un circuit (7) de lecture d'un état initial de la cellule et de stabilisation de cet état en provoquant une diminution, stable et irréversible dans la plage de courants de fonctionnement en lecture de la cellule, de la valeur de la résistance (Rd, Rg) associée à la branche fournissant un état haut en sortie.

2. Cellule selon la revendication 1, **caractérisée en ce que** ladite diminution de valeur est provoquée en imposant temporairement, dans la résistance correspondante (Rd, Rg), la circulation d'un courant qui soit supérieur au courant pour lequel la valeur de cette résistance est maximum.

3. Cellule selon la revendication 1 ou 2, **caractérisée en ce que** chaque branche comporte en outre un transistor de stabilisation (MN3d, MN3g) reliant sa borne de sortie (Q, NQ) à ladite borne (3) d'application de tension opposée à celle à laquelle est connectée la résistance (Rd, Rg) de la branche concernée.

4. Cellule selon l'une quelconque des revendications 1 à 3, **caractérisée en ce que** les transistors de stabilisation (MN3d, MN3g) servent à provoquer ladite diminution de la valeur d'une des résistances (Rd, Rg).

5. Cellule selon l'une quelconque des revendications 1 à 4, **caractérisée en ce que** ladite tension est choisie entre une tension relativement faible de lecture (Vr) et une tension relativement élevée de stabilisation (Vp) de l'état initial de la cellule.

6. Cellule selon l'une quelconque des revendications 1 à 5, **caractérisée en ce que** lesdits transistors sont des transistors MOS à canal N.

7. Cellule selon l'une quelconque des revendications 1 à 5, **caractérisée en ce que** lesdits transistors sont des transistors MOS à canal P.

8. Procédé de commande en stabilisation de la valeur d'une cellule (1) d'extraction d'une valeur binaire à partir d'une propagation d'un front d'un signal de déclenchement dans deux chemins électriques, comprenant entre deux bornes (2, 3) d'application d'une tension, deux branches parallèles comprenant chacune, en série:

une résistance (Rd, Rg) de différenciation des chemins électriques ;

un transistor de lecture (MN1d, MN1g), le point milieu entre la résistance et le transistor de lecture de chaque branche définissant une borne de sortie (Q, NQ) de la cellule, et la grille du transistor de lecture de chaque branche étant reliée à la borne de sortie de l'autre branche ; et

un transistor de sélection (MN2d, MN2g), **caractérisé en ce** qui comprend les étapes suivantes :

provoquer une lecture d'un état initial de la cellule ; et

soumettre temporairement, celle des résistances qui est associée à la branche fournissant un état haut en sortie, à un courant de contrainte supérieur à un courant (Im) pour lequel la valeur de la résistance présente un maximum.

9. Procédé selon la revendication 8, **caractérisé en ce que** le courant de contrainte est choisi dans une table prédéterminée de correspondance entre le courant de contrainte et la résistance finale souhaitée.

10. Circuit de stockage et d'extraction d'un code binaire sur n bits dans une puce de circuit intégré comportant :

n cellules (1) conformes à l'une quelconque des revendications 1 à 7 ; et
une unité centrale (4) de commande.

11. Circuit selon la revendication 10, **caractérisé en ce que** les n bits contenus dans les cellules (1) sont extraits en parallèles.

12. Circuit d'identification d'une puce de circuit intégré, **caractérisé en ce qu'**il comporte un circuit conforme à la revendication 10 ou 11.

**Claims**

1. An integrated cell (1) for extracting a binary value based on a propagation of an edge of a triggering signal in two electric paths, comprising, across two voltage supply terminals (2, 3), two parallel branches each comprising, in series:

a resistor (Rd, Rg) for differenciating the electric paths;
a read transistor (MN1d, MN1g), the junction of the resistor and the read transistor of each branch defining an output terminal (Q, NQ) of the cell, and the gate of the read transistor of each branch being connected to the output terminal of the other branch; and

a selection transistor (MN2d, MN2g), **characterized in that** the resistors (Rd, Rg) are made of polysilicon and are sized to have identical nominal values, the cell being associated with a circuit (7) for reading an initial state of the cell and for stabilizing this state by causing a stable and irreversible decrease, in the cell read operating current range, of the resistance (Rd, Rg) associated with the branch outputting a high state.

2. The cell of claim 1, **characterized in that** said resistance decrease is caused by temporarily imposing, in the corresponding resistor (Rd, Rg), a current which is greater than the current for which the value of the resistance is maximum.

3. The cell of claim 1 or 2, **characterized in that** each branch further comprises a stabilization transistor (MN3d, MN3g) connecting its output terminal (Q, NQ) to said terminal (3) of application of a voltage opposite to that to which the resistor (Rd, Rg) of the involved branch is connected.

4. The cell of any of claims 1 to 3, **characterized in that** the stabilization transistors (MN3d, MN3g) are used to cause said decrease in the value of one of the resistors (Rd, Rg).

5. The cell of any of claims 1 to 4, **characterized in that** said voltage is chosen between a relatively low read voltage (Vr) and a relatively high voltage of stabilization (Vp) of the initial cell state.

6. The cell of any of claims 1 to 5, **characterized in that** said transistors are N-channel MOS transistors.

7. The cell of any of claims 1 to 5, wherein said transistors are P-channel MOS transistors.

8. A method for controlling the stabilization of the value of a cell (1) for extracting a binary value based on a propagation of an edge of a triggering signal in two electric paths, comprising, across two voltage supply terminals (2, 3), two parallel branches each comprising, in series:

a resistor (Rd, Rg) for differenciating the electric paths;
a read transistor (MN1d, MN1g), the junction of the resistor and the read transistor of each branch defining an output terminal (Q, NQ) of the cell, and the gate of the read transistor of each branch being connected to the output terminal of the other branch; and
a selection transistor (MN2d, MN2g), **characterized in that** it comprises the steps of:
causing the reading of an initial state of the cell;

and

temporarily submitting that of the resistors which is associated with the branch providing a high output state, to a constraint current greater than a current (Im) for which the value of the resistance exhibits a maximum.

9. The method of claim 8, **characterized in that** the constraint current is selected from a predetermined table of correspondence between the constraint current and the desired final resistance.

10. A circuit for storing and extracting a binary code over n bits in and from an integrated circuit chip, comprising:

    n cells (1) of any of claims 1 to 7; and
    a central control unit (4).

11. The circuit of claim 10, **characterized in that** the n bits contained in the cells (1) are extracted in parallel.

12. A circuit for identifying an integrated circuit chip **characterized in that** it comprises the circuit of claim 10 or 11.

## Patentansprüche

1. Eine integrierte Zelle (1) zum Extrahieren eines binären Wertes, basierend auf einer Ausbreitung von einer Kante bzw. Flanke von einem auslösenden Signal in zwei elektrischen Pfaden, wobei die Zelle über zwei Spannungsversorgungsterminals bzw. -anschlüsse (2, 3) zwei parallele Zweige aufweist, die jeweils in Reihe Folgendes aufweisen:

    einen Widerstand (Rd, Rg) zum Differenzieren der elektrischen Pfade;
    einen Lesetransistor (MN1d, MN1g), wobei der Übergang von dem Widerstand und dem Lesetransistor von jedem Zweig einen Ausgangsanschluss (Q, NQ) von der Zelle definiert und das Gatter von dem Lesetransistor von jedem Zweig mit dem Ausgangsanschluss von dem anderen Zweig verbunden ist;
    einen Auswahltransistor (MN2d, MN2g), **dadurch gekennzeichnet, dass** die Widerstände (Rd, Rg) aus Polysilizium hergestellt sind, und ausgelegt sind, so dass sie identische Nominalwerte bzw. Nennwerte besitzen, wobei die Zelle mit einer Schaltung (7) assoziiert ist, zum Lesen eines Anfangszustands von der Zelle und
    zum Stabilisieren dieses Zustands durch Bewirken einer stabilen und irreversiblen Abnahme in dem Zellenlesebetriebsstrombereich von dem Widerstand (Rd, Rg), der mit dem Zweig assoziiert ist, der einen hohen Zustand (high state) ausgibt.

2. Zelle nach Anspruch 1, **dadurch gekennzeichnet, dass** die Widerstandsabnahme bewirkt wird durch temporäres Auferlegen bzw. Einprägen, in dem entsprechenden Widerstand (Rd, Rg), eines Stroms der größer ist, als der Strom für den der Wert von dem Widerstand maximal ist.

3. Zelle nach Anspruch 1 oder 2, **dadurch gekennzeichnet, dass** jeder Zweig ferner einen Stabilisierungstransistor (MN3d, MN3g) aufweist, der seinen Ausgangsanschluss (Q, NQ) mit dem Anschluss (3) zum Anlegen von einer Spannung entgegengesetzt zu jener verbindet, mit der der Widerstand (Rd, Rg) von dem einbezogenen Zweig verbunden ist.

4. Zelle nach irgendeinem der Ansprüche 1 bis 3, **dadurch gekennzeichnet, dass** die Stabilisierungstransistoren (MN3d, MN3g) genutzt werden, um die Abnahme in dem Wert von einem von den Widerständen (Rd, Rg) zu bewirken.

5. Zelle nach irgendeinem der Ansprüche 1 bis 4, **dadurch gekennzeichnet, dass** die Spannung gewählt wird zwischen einer relativen niedrigen Lesespannung (Vr) und einer relativ hohen Stabilisierungsspannung (Vp) von dem anfänglichen Zellenzustand.

6. Zelle nach irgendeinem der Ansprüche 1 bis 5, **dadurch gekennzeichnet, dass** die Transistoren N-Kanal-MOS-Transistoren sind.

7. Zelle nach irgendeinem der Ansprüche 1 bis 5, wobei die Transistoren P-Kanal-MOS-Transistoren sind.

8. Ein Verfahren zum Steuern der Stabilisierung von dem Wert von einer Zelle (1) zum Extrahieren eines binären Werts, basierend auf einer Ausbreitung von einer Kante bzw. Flanke von einem auslösenden Signal in zwei elektrischen Pfaden, aufweisend, über zwei Spannungsversorgungsanschlüsse bzw. -terminals (2, 3) zwei parallele Zweige, die jeweils in Reihe Folgendes aufweisen:

    einen Widerstand (Rd, Rg) zum Differenzieren der elektrischen Pfade;
    einen Lesetransistor (MN1d, MN1g), wobei der Übergang von dem Widerstand und dem Lesetransistor von jedem Zweig einen Ausgangsanschluss (Q, NQ) von der Zelle definiert und das Gatter von dem Lesetransistor von jedem Zweig mit dem Ausgangsanschluss von dem anderen Zweig verbunden ist; und
    einen Auswahltransistor (MN2d, MN2g), **dadurch gekennzeichnet, dass** es die folgenden Schritte aufweist:

Bewirken des Lesens von einem Anfangszustand von der Zelle; und temporäres Aussetzen bzw. Einprägen jenes der Transistoren, der mit dem Zweig, der einen hohen Ausgangszustand vorsieht, assoziiert ist, mit einen eingeprägten Strom, der größer ist als ein Strom (Im) für den der Wert von dem Widerstand ein Maximum zeigt.

9. Verfahren nach Anspruch 8, **dadurch gekennzeichnet, dass** der eingeprägte Strom aus einer vorherbestimmten Korrespondenztabelle zwischen dem eingeprägten Strom und dem gewünschten finalen Widerstand ausgewählt wird.

10. Eine Schaltung zum Speichern und Extrahieren eines binären Codes über n-Bits in und aus einem integrierten Schaltungs-Chip, wobei der Schaltkreis Folgendes aufweist:

    n-Zellen (1) nach irgendeinem der Ansprüche 1 bis 7; und
    eine zentrale Steuereinheit (4).

11. Schaltung nach Anspruch 10, **dadurch gekennzeichnet, dass** die n-Bits, die in den Zellen 1 enthalten sind, parallel extrahiert werden.

12. Eine Schaltung zum Identifizieren eines integrierten Schaltungs-Chips, **dadurch gekennzeichnet, dass** es die Schaltung nach Anspruch 10 oder 11 aufweist.

Fig 1

Fig 4

Fig 2

Fig 3

14

**EP 1 476 872 B1**

**RÉFÉRENCES CITÉES DANS LA DESCRIPTION**

**Documents brevets cités dans la description**

- US 3636530 A

- GB 2107541 A